# EUROPEAN PATENT APPLICATION

(11) **EP 4 435 863 A1**
(43) Date of publication of application: **25.09.2024**
(21) Application number: 24163537.4
(22) Date of filing: 14.03.2024
(51) Int. Cl.: H01L 27/146

(54) **IMAGE SENSORS**

(30) Priority: 24.03.2023 KR 20230039296
(71) Applicant: Samsung Electronics Co., Ltd., Suwon-si, Gyeonggi-do 16677 (KR)
(72) Inventor: FUJITA, Masato, 16677 Suwon-si, Gyeonggi-do (KR); KIM, Jaewoong, 16677 Suwon-si, Gyeonggi-do (KR)
(74) Representative: Kuhnen & Wacker Patent- und Rechtsanwaltsbüro PartG mbB

(57) **Abstract**

An image sensor includes: a first stack including: a first semiconductor substrate including a first surface and a second surface opposite to the first surface, a photoelectric conversion region in the first semiconductor substrate, and a floating diffusion region in the first semiconductor substrate, the floating diffusion region being configured to store charges transferred from the photoelectric conversion region; a second stack including: a second semiconductor substrate including a first surface and a second surface opposite the first surface, and a transmission gate penetrating through the second semiconductor substrate and extending into the first stack; and an insulation layer between the first stack and the second stack.

## Description

### BACKGROUND

### 1. Field

The disclosure relates to an image sensor, and more particularly, to an image sensor including a photodiode.

### 2. Description of Related Art

An image sensor converts an optical image signal into an electrical signal. An image sensor may include a plurality of pixels that receive incident light, convert the incident light into an electrical signal, and include a photodiode region. As the degree of integration of an image sensor increases, the size of the pixel decreases, and thus, the size of the electrical connection components of a pixel circuit for driving the pixel also decreases. As a result, noise may occur or photoelectric conversion efficiency (such as conversion gain) may be deteriorated.

### SUMMARY

Provided is an image sensor having excellent image quality even with a small pixel size.

According to an aspect of the disclosure, an image sensor includes: a first stack including: a first semiconductor substrate including a first surface and a second surface opposite to the first surface, a photoelectric conversion region in the first semiconductor substrate, and a floating diffusion region in the first semiconductor substrate, the floating diffusion region being configured to store charges transferred from the photoelectric conversion region; a second stack including: a second semiconductor substrate including a first surface and a second surface opposite the first surface, and a transmission gate penetrating through the second semiconductor substrate and extending into the first stack; and an insulation layer between the first stack and the second stack.

According to another aspect of the disclosure, an image sensor includes: a first stack including: a first semiconductor substrate including a first surface and a second surface opposite to the first surface, a photoelectric conversion region in the first semiconductor substrate, and a floating diffusion region in the first semiconductor substrate, the floating diffusion region being configured to store charges transferred from the photoelectric conversion region; a second stack including: a second semiconductor substrate including a first surface that faces the first surface of the first semiconductor substrate, and a second surface opposite the first surface, a pixel gate on the first surface of the second semiconductor substrate, and a transmission gate including a first end portion disposed at a level higher than that of the first surface of the first semiconductor substrate and a second end portion disposed at a level lower than that of the first surface of the second semiconductor substrate; and an insulation layer between the first stack and the second stack, wherein a portion of a sidewall of the transmission gate is surrounded by the insulation layer.

According to another aspect of the disclosure, an image sensor includes: a first stack including: a first semiconductor substrate including a first surface and a second surface opposite to the first surface, a photoelectric conversion region in the first semiconductor substrate, and a floating diffusion region in the first semiconductor substrate, the floating diffusion region being configured to store charges transferred from the photoelectric conversion region; a second stack including: a second semiconductor substrate including a first surface that faces the first surface of the first semiconductor substrate, and a second surface opposite the first surface, a pixel gate on the first surface of the second semiconductor substrate, and a transmission gate including a first end portion at a level higher than that of the first surface of the first semiconductor substrate and a second end portion at a level lower than that of the first surface of the second semiconductor substrate; a first insulation layer between the first stack and the second stack; a third stack including: a third semiconductor substrate and a logic transistor on the third semiconductor substrate, the logic transistor being configured to provide signals to the pixel gate and the transmission gate; and a second insulation layer between the second stack and the third stack.

### BRIEF DESCRIPTION OF DRAWINGS

Embodiments of the disclosure will be more clearly understood from the following detailed description taken in conjunction with the accompanying drawings in which:
FIG. 1 is a schematic perspective view of an image sensor according to embodiments;
FIG. 2 is a layout diagram showing a first stack corresponding to one pixel of FIG. 1;
FIG. 3 is a layout diagram showing a second stack corresponding to one pixel of FIG. 1;
FIG. 4 is a cross-sectional view taken along a line A1-A1' of FIG. 3;
FIGS. 5 and 6 are enlarged views of CX1 of FIG. 4;
FIG. 7 is a circuit diagram of pixels of an image sensor according to embodiments;
FIG. 8 is a cross-sectional view of an image sensor according to embodiments;
FIG. 9 is an enlarged view of a portion CX1 of FIG. 8;
FIG. 10 is a layout diagram showing a first stack of an image sensor according to embodiments;
FIG. 11 is a layout diagram showing a second stack of an image sensor according to embodiments;
FIG. 12 is a cross-sectional view taken along a line A2-A2' of FIG. 11;
FIG. 13 is an enlarged view of a portion CX2 of FIG. 12;
FIG. 14 is a cross-sectional view of an image sensor according to embodiments;
FIG. 15 is an enlarged view of a portion CX2 of FIG. 14;
FIG. 16 is a layout diagram showing an image sensor according to embodiments;
FIG. 17 is a cross-sectional view of the image sensor of FIG. 16;
FIG. 18 is a layout diagram showing an image sensor according to embodiments;
FIGS. 19 and 20 are diagrams schematically showing pixel transistors that may be employed in an image sensor according to embodiments;
FIGS. 21 to 33 are cross-sectional views of an operational procedure of manufacturing an image sensor according to example embodiments; and
FIG. 34 is a block diagram showing the configuration of an image sensor according to an embodiment.

### DETAILED DESCRIPTION

Before undertaking the detailed description below, it may be advantageous to set forth definitions of certain words and phrases used throughout the disclosure. The term "or" is an inclusive term meaning "and/or". The term "controller" refers to any device, system, or part thereof that controls at least one operation. Such a controller may be implemented in hardware or a combination of hardware and software and/or firmware. The functionality associated with any particular controller may be centralized or distributed, whether locally or remotely. The phrase "at least one of," when used with a list of items, means that different combinations of one or more of the listed items may be used, and only one item in the list may be needed. For example, "at least one of A, B, and C" includes any of the following combinations: A, B, C, A and B, A and C, B and C, and A and B and C, and any variations thereof. Definitions for other certain words and phrases are provided throughout this disclosure. Those of ordinary skill in the art should understand that in many if not most instances, such definitions apply to prior as well as future uses of such defined words and phrases.

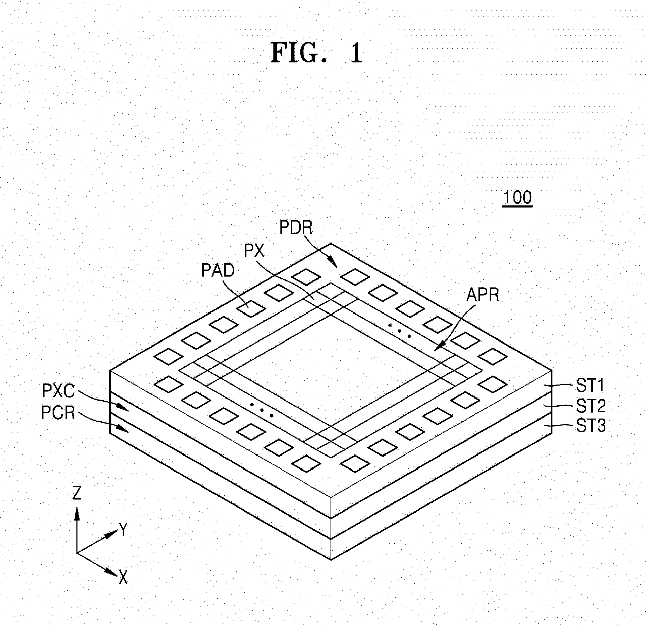

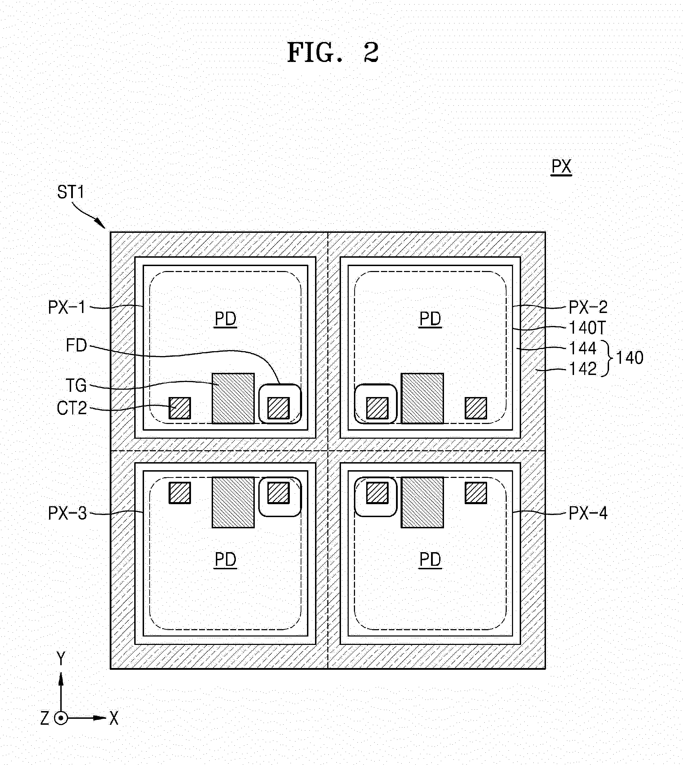

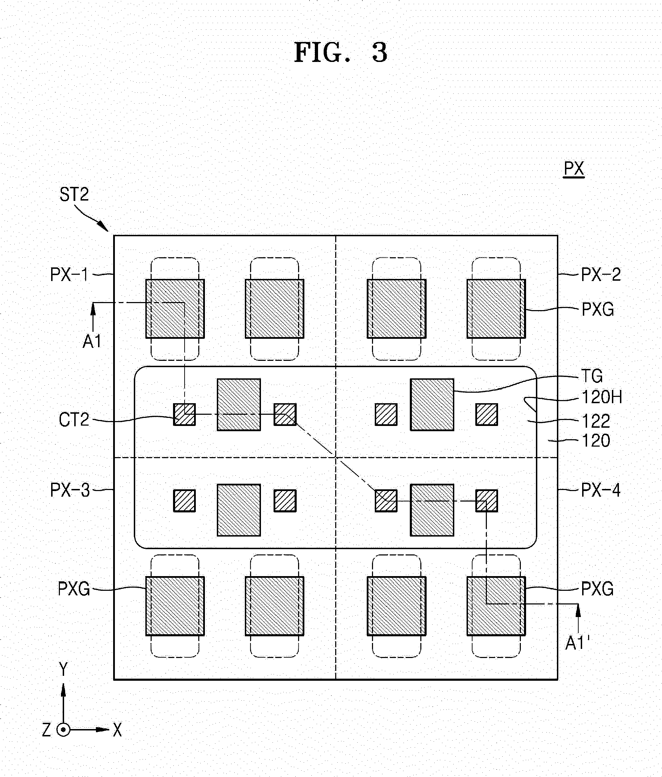

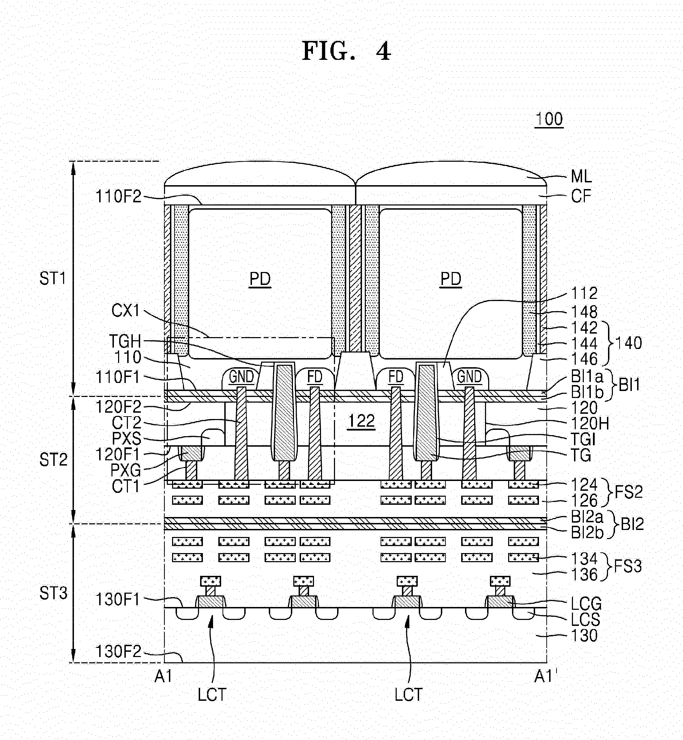

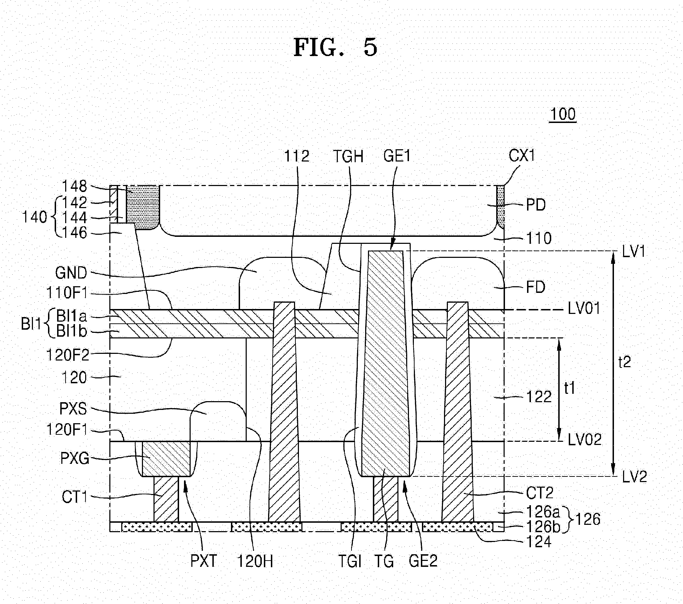

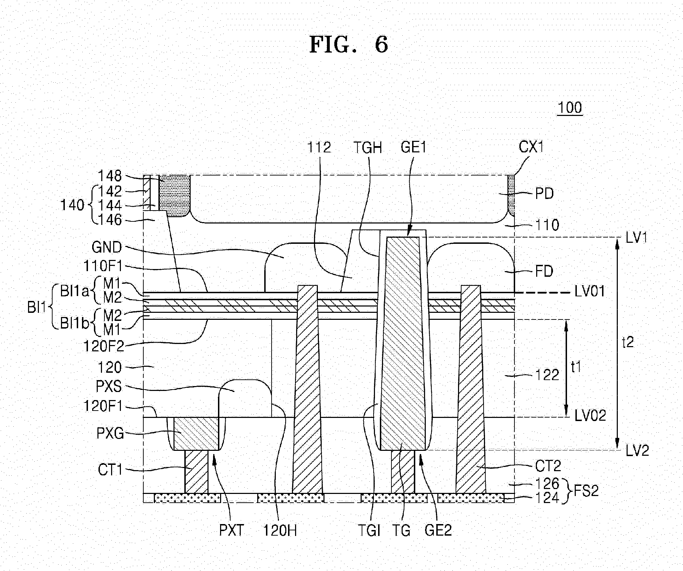

FIG. 1 is a schematic perspective view of an image sensor 100 according to embodiments. FIG. 2 is a layout diagram showing a first stack ST1 corresponding to one pixel PX of FIG. 1, and FIG. 3 is a layout diagram showing a second stack ST2 corresponding to one pixel PX of FIG. 1. FIG. 4 is a cross-sectional view taken along a line A1-A1' of FIG. 3. FIGS. 5 and 6 are enlarged views of CX1 of FIG. 4.

Referring to FIGS. 1 to 6, the image sensor 100 may be a stacked image sensor in which the first stack ST1, the second stack ST2, and a third stack ST3 are stacked in a vertical direction.

In one embodiment, an active pixel region APR may be disposed at the center of the image sensor 100 and a plurality of pixels PX may be arranged in the active pixel region APR. The plurality of pixels PX may be regions that receive light from the outside of the image sensor 100 and convert the light into electrical signals. The plurality of pixels PX may be arranged in the first stack ST1 and the second stack ST2. For example, a photoelectric conversion region PD for receiving external light may be disposed in the first stack ST1, and transistors constituting a pixel circuit PXC for converting photocharges accumulated in the photoelectric conversion region PD into electrical signals may be disposed in the second stack ST2.

A pad region PDR may be disposed on at least one side of the active pixel region APR, e.g., on four sides of the active pixel region APR in a plan view. A plurality of pads PAD may be disposed in the pad region PDR and may be configured to transmit and receive electrical signals to and from external devices.

A peripheral circuit region PCR may include a logic circuit block and/or a memory device. For example, the logic circuit block may include a plurality of logic transistors LCT and may provide a constant signal to a pixel PX of the active pixel region APR, or control an output signal from a pixel PX. For example, the logic transistors LCT may include at least one of a row decoder, a row driver, a column decoder, a timing generator, a correlated double sampler (CDS), an analog-to-digital converter, and an input/output (I/O) buffer.

The active pixel region APR may include the plurality of pixels PX, and a plurality of photoelectric conversion regions PD may be arranged in the plurality of pixels PX, respectively. In the active pixel region APR, the pixels PX may constitute columns and rows in a first direction X parallel to the top surface of a first semiconductor substrate 110 and a second direction Y perpendicular to the first direction X and parallel to the top surface of the first semiconductor substrate 110 and arranged in a matrix-like shape. Some of the plurality of pixels PX may be optical black pixels. The optical black pixels may function as reference pixels for the active pixel region APR and may perform a function for automatically correcting a dark signal.

The first stack ST1 may include the first semiconductor substrate 110 having a first surface 110F1 and a second surface 110F2 and may include a color filter CF and a micro lens ML arranged on the second surface 110F2 of the first semiconductor substrate 110. The second stack ST2 may include a second semiconductor substrate 120 having a first surface 120F1 and a second surface 120F2 and may include a pixel transistor PXT, a transmission gate TG, and a front structure FS2 arranged on the first surface 120F1 of the second semiconductor substrate 120. The transmission gate TG may extend from the inside of the second stack ST2 toward the inside of the first stack ST1, e.g., toward the inside of the first semiconductor substrate 110. The third stack ST3 may include a third semiconductor substrate 130 having a first surface 130F1 and a second surface 130F2 and may include a logic transistor LCT and a front structure FS3 arranged on the first surface 130F1 of the third semiconductor substrate 130.

The second stack ST2 is disposed between the first stack ST1 and the third stack ST3, such that, for example, the front structure FS2 of the second stack ST2 faces the front structure FS3 of the third stack ST3 and the second surface 120F2 of the second semiconductor substrate 120 included in the second stack ST2 faces the first surface 110F1 of the first semiconductor substrate 110 included in the first stack ST1.

The first stack ST1 and the second stack ST2 may be attached to each other via a first insulation layer BI1 therebetween. The second stack ST2 and the third stack ST3 may be attached to each other via a second insulation layer BI2 therebetween. According to some embodiments, a bonding pad surrounded by the second insulation layer BI2 may be further disposed between the second stack ST2 and the third stack ST3.

According to embodiments, a first semiconductor substrate 110, a second semiconductor substrate 120, and a third semiconductor substrate 130 may include P-type semiconductor substrates. For example, at least one of the first semiconductor substrate 110, the second semiconductor substrate 120, and the third semiconductor substrate 130 may include a P-type silicon substrate. According to embodiments, at least one of the first semiconductor substrate 110, the second semiconductor substrate 120, and the third semiconductor substrate 130 may include a P-type bulk substrate and a P-type or N-type epitaxial layer grown thereon. According to other embodiments, at least one of the first semiconductor substrate 110, the second semiconductor substrate 120, and the third semiconductor substrate 130 may include an N-type bulk substrate and a P-type or N-type epitaxial layer grown thereon. According to some embodiments, the second semiconductor substrate 120 may include a portion having a silicon-on-insulator (SOI) structure and, for example, may include a silicon layer having the SOI structure.

A pixel isolation structure 140 may be disposed in the first stack ST1 in the active pixel region APR. The plurality of pixels PX may be defined by the pixel isolation structure 140. The pixel isolation structure 140 may include a conductive layer 142, an insulation liner 144, and an upper insulation layer 146. The conductive layer 142 may be disposed inside a pixel trench 140T penetrating through the first semiconductor substrate 110. The insulation liner 144 may be disposed on inner walls of the pixel trench 140T penetrating through the first semiconductor substrate 110, may extend from the first surface 1 10F1 of the first semiconductor substrate 110 to the second surface 110F2 of the first semiconductor substrate 110, and may be disposed between the conductive layer 142 and the first semiconductor substrate 110. The upper insulation layer 146 may be disposed in a portion of the pixel trench 140T adjacent to the first surface 110F1 of the first semiconductor substrate 110.

According to embodiments, the conductive layer 142 may include at least one of doped polysilicon, a metal, a metal silicide, a metal nitride, or a metal-containing layer. The insulation liner 144 may include an insulating material such as silicon oxide, silicon nitride, or silicon oxynitride. The upper insulation layer 146 may include an insulating material such as silicon oxide, silicon nitride, or silicon oxynitride.

At least one region of the plurality of photoelectric conversion regions PD may be disposed in the first stack ST1 of the plurality of pixels PX. The photoelectric conversion region PD may be a region doped with an n-type impurity. For example, the photoelectric conversion region PD may have a potential gradient due to a difference in impurity concentrations between an upper portion of the photoelectric conversion region PD and a lower portion of the photoelectric conversion region PD. Alternatively, the photoelectric conversion region PD may be formed in a form in which a plurality of impurity regions are stacked in a vertical direction.

A liner region 148 surrounding the at least one region of the plurality of photoelectric conversion regions PD may be selectively disposed in a portion of the first semiconductor substrate 110. The liner region 148 may be disposed between the pixel isolation structure 140 and the photoelectric conversion region PD and may be a region doped with a p-type impurity.

A floating diffusion region FD may be disposed in an inner region of the first semiconductor substrate 110 adjacent to the first surface 110F1 of the first semiconductor substrate 110. The floating diffusion region FD may be a region in which charges transferred from the photoelectric conversion region PD are stored. A ground region GND may be disposed in an inner region of the first semiconductor substrate 110 adjacent to the first surface 110F1 of the first semiconductor substrate 110. According to some embodiments, at least a portion of the ground region GND may be surrounded by the device isolation layer 112.

The first surface 110F1 of the first semiconductor substrate 110 may be disposed to face the second surface 120F2 of the second semiconductor substrate 120. The first insulation layer BI1 may be disposed between the first surface 110F1 of the first semiconductor substrate 110 and the second surface 120F2 of the second semiconductor substrate 120. The first insulation layer BI1 may have a stacked structure of a first sub-bonding layer BI1a and a second sub-bonding layer BI1b. For example, the first insulation layer BI1 may be disposed to entirely cover the first surface 110F1 of the first semiconductor substrate 110. For example, as shown in FIG. 4, the second sub-bonding layer BI1b may be disposed on the second surface 120F2 of the second semiconductor substrate 120 with a uniform thickness, the first sub-bonding layer BI1a may be disposed on the second sub-bonding layer BI1b with a uniform thickness, and the first surface 1 10F1 of the first semiconductor substrate 110 may be disposed on the first sub-bonding layer BI1a to face the second surface 120F2 of the second semiconductor substrate 120.

According to embodiments, the first sub-bonding layer BI1a and the second sub-bonding layer BI1b may include silicon oxide or silicon carbon nitride. A bonding interface between the first sub-bonding layer BI1a and the second sub-bonding layer BI1b may have a flat profile. For example, as shown in FIG. 5, the first sub-bonding layer BI1a or the second sub-bonding layer BI1b may include a single material layer, and a stacked structure of the first sub-bonding layer BI1a and the second sub-bonding layer BI1b may be disposed between the first surface 110F1 of the first semiconductor substrate 110 and the second surface 120F2 of the second semiconductor substrate 120 without interposing an additional material layer. In other words, the first surface 110F1 of the first semiconductor substrate 110 may directly contact the first sub-bonding layer BI1a, and the second surface 120F2 of the second semiconductor substrate 120 may directly contact the second sub-bonding layer BI1b. According to some embodiments, the first sub-bonding layer BI1a may include silicon oxide, and the second sub-bonding layer BI1b may include silicon oxide. According to other embodiments, the first sub-bonding layer BI1a may include silicon carbon nitride and the second sub-bonding layer BI1b may include silicon carbon nitride.

According to some embodiments, as shown in FIG. 6, the first sub-bonding layer BI1a and the second sub-bonding layer BI1b may include a double layer of a first material layer M1 and a second material layer M2, wherein the first material layer M1 and the second material layer M2 of first sub-bonding layer BI1a may be sequentially arranged on the first surface 110F1 of the first semiconductor substrate 110, the first material layer M1 and the second material layer M2 of the second sub-bonding layer BI1b may be sequentially arranged on the second surface 120F2 of the second semiconductor substrate 120, and the second material layer M2 of the first sub-bonding layer BI1a and the second material layer M2 of the second sub-bonding layer BI1b may constitute a bonding interface. According to some embodiments, the first material layer M1 of the first sub-bonding layer BI1a and the first material layer M1 of the second sub-bonding layer BI1b may include silicon oxide, and the second material layer M2 of the first sub-bonding layer BI1a and the second material layer M2 of the second sub-bonding layer BI1b may include silicon carbon nitride. According to other embodiments, the first material layer M1 of the first sub-bonding layer BI1a and the first material layer M1 of the second sub-bonding layer BI1b may include silicon carbon nitride, and the second material layer M2 of the first sub-bonding layer BI1a and the second material layer M2 of the second sub-bonding layer BI1b may include silicon oxide.

The pixel transistor PXT may be disposed in the second stack ST2 in the active pixel region APR. The pixel transistor PXT may be disposed on the first surface 120F1 of the second semiconductor substrate 120. For example, the pixel transistor PXT may include a pixel gate PXG and a source/drain region PXS. The source/drain region PXS may be disposed inside a portion of the second semiconductor substrate 120 adjacent to the pixel gate PXG. The pixel gate PXG may include at least one of doped polysilicon, a metal, a metal silicide, a metal nitride, or a metal-containing layer. A gate insulation layer may be disposed between the first surface 120F1 of the second semiconductor substrate 120 and the pixel gate PXG.

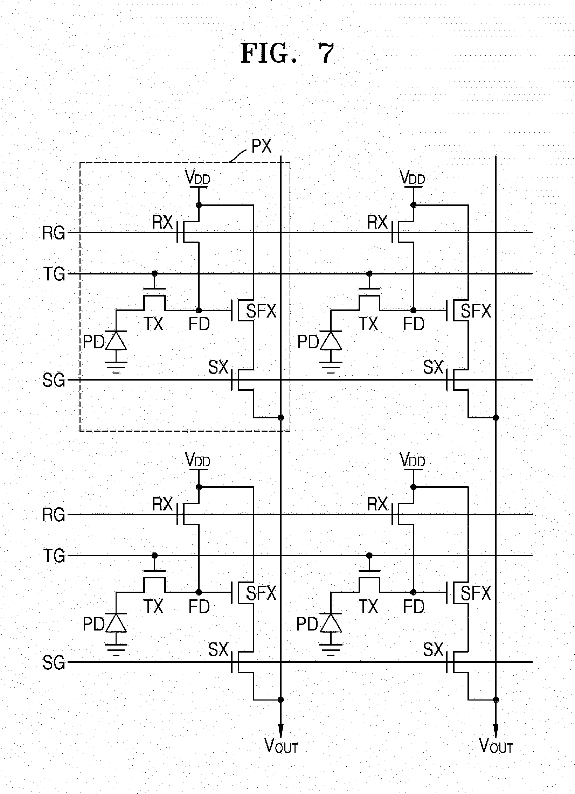

According to embodiments, the pixel transistor PXT may be configured to provide signals to the photoelectric conversion region PD and the floating diffusion region FD arranged in the first stack ST1. For example, the pixel transistor PXT may include a source follower transistor SFX (e.g., in FIG. 7), a selection transistor SX, and a reset transistor RX. For example, the photoelectric conversion region PD and/or the floating diffusion region FD disposed inside the first stack ST1 of one pixel PX may be electrically connected to the pixel gate PXG disposed inside the second stack ST2 inside the one pixel PX. For example, the photoelectric conversion region PD and/or the floating diffusion region FD disposed inside the first stack ST1 of one pixel PX may be electrically connected to pixel gates PXG constituting the source follower transistor SFX (refer to FIG. 7), the selection transistor SX (e.g., in FIG. 7), and the reset transistor RX (refer to FIG. 7) arranged inside the second stack ST2 inside the one pixel PX.

According to embodiments, the reset transistor RX may be configured to periodically reset charges stored in the floating diffusion region FD. The source follower transistor SFX serves as a source follower buffer amplifier and may be configured to buffer signals according to charges charged in the floating diffusion region FD. The selection transistor SX may perform a switching and addressing function for selecting the pixel PX.

A filling insulation layer 122 may be disposed in an opening 120H penetrating through the second semiconductor substrate 120. The filling insulation layer 122 may include a top surface positioned on the same plane as the second surface 120F2 of the second semiconductor substrate 120 and a bottom surface positioned on the same plane as the first surface 120F1 of the second semiconductor substrate 120, and the filling insulation layer 122 may have a thickness substantially identical to a first thickness t1 of the second semiconductor substrate 120.

The transmission gate TG may extend from inside the second stack ST2 to the inside of the first stack ST1, penetrate through the second semiconductor substrate 120, and extend toward the inside of the first semiconductor substrate 110 in a vertical direction Z. For example, the transmission gate TG may extend in the vertical direction Z through the filling insulation layer 122 disposed in the opening 120H of the second semiconductor substrate 120.

According to embodiments, the transmission gate TG may include a first end portion GE1 located at a first vertical level LV1 higher than that of the first surface 110F1 of the first semiconductor substrate 110 (e.g., a first reference level LV01) and a second end portion GE2 located at a second vertical level LV2 lower than that of the first surface 120F1 of the second semiconductor substrate 120 (e.g., a second reference level LV02). Here, the first end portion GE1 refers to the uppermost surface of the transmission gate TG (e.g., the surface of the transmission gate TG disposed inside the first semiconductor substrate 110), and the second end portion GE2 refers to the lowermost surface of the transmission gate TG (e.g., the surface of the transmission gate TG covered by the front structure FS2).

According to embodiments, since the transmission gate TG penetrates through the second semiconductor substrate 120 and extends in the vertical direction Z, a portion of the sidewall of the transmission gate TG adjacent to the first end portion GE1 may be surrounded by the first semiconductor substrate 110 and the first insulation layer BI1, and a portion of the sidewall of the transmission gate TG adjacent to the second end portion GE2 may be surrounded by the front structure FS2 and the filling insulation layer 122.

As shown in FIG. 5, a transmission gate trench TGH may extend in the vertical direction Z toward the inside of the first semiconductor substrate 110 through the filling insulation layer 122 and the first insulation layer BI1, and the transmission gate TG may be disposed in the transmission gate trench TGH. A transmission gate insulation layer TGI may be disposed on the inner wall of the transmission gate trench TGH, thereby electrically insulating the transmission gate TG from the first semiconductor substrate 110. Therefore, the transmission gate insulation layer TGI may be disposed between the transmission gate TG and the first insulation layer BI1 and between the transmission gate TG and the filling insulation layer 122, and thus the transmission gate TG may not directly contact the first insulation layer BI1 and/or the filling insulation layer 122.

According to embodiments, the transmission gate TG may have a second thickness t2 greater than the first thickness t1 of the second semiconductor substrate 120. The transmission gate TG may be formed at the same time as the pixel gate PXG, and thus the second end portion GE2 of the transmission gate TG may be located on the same plane as the top surface of the pixel gate PXG (e.g., the bottom surface of the pixel gate PXG shown in FIG. 4).

The front structure FS2 covering the first surface 120F1 of the second semiconductor substrate 120 may be disposed in the second stack ST2. The front structure FS2 may include a wiring layer 124 and a cover insulation layer 126. The cover insulation layer 126 may be formed as a stacked structure of a plurality of insulation layers and may be disposed to contact the first surface 120F1 of the second semiconductor substrate 120 and cover the wiring layer 124 and the pixel gate PXG. The cover insulation layer 126 may be formed as a stacked structure of a plurality of insulation layers. For example, the cover insulation layer 126 may include a first cover insulation layer 126a and a second cover insulation layer 126b, the first cover insulation layer 126a be disposed to cover the pixel gate PXG and the transmission gate TG, and the second cover insulation layer 126b may be disposed to cover the wiring layer 124.

According to embodiments, the front structure FS2 may further include a first contact CT1 and a second contact CT2. The first contact CT1 may electrically connect the pixel gate PXG to the wiring layer 124. The second contact CT2 may electrically connect the floating diffusion region FD or the ground region GND in the first stack ST1 to the wiring layer 124 in the front structure FS2. The second contact CT2 may extend in the vertical direction Z from the inside of the second stack ST2 toward the inside of the first stack ST1, and a portion of the sidewall of the second contact CT2 may be surrounded by the first cover insulation layer 126a, the filling insulation layer 122, and the first insulation layer BI1.

According to embodiments, the first contact CT1 or the second contact CT2 may include at least one of copper (Cu), tungsten (W), cobalt (Co), titanium (Ti), ruthenium (Ru), molybdenum (Mo), and titanium nitride (TiN).

According to some embodiments, as shown in FIGS. 2 and 3, a first pixel PX-1, a second pixel PX-2, a third pixel PX-3, and a fourth pixel PX-4 may be arranged in a matrix-like shape. At least one of the first to fourth pixels PX-1, PX-2, PX-3, and PX-4 in the first stack ST1 may have the transmission gate TG and the floating diffusion region FD. The first pixel PX-1 and the third pixel PX-3 arranged side-by-side in a second direction Y may have mirror- symmetrical shapes with respect to each other, and the first pixel PX-1 and the second pixel PX-2 arranged side-by-side in a first direction X may have mirror-symmetrical shapes with respect to each other. The layout of the pixel PX shown in FIGS. 5 and 6 is merely an example, and, for example, sizes, shapes, and positions of the transmission gate TG and the pixel gate PXG are not limited to those shown in FIGS. 2 and 3.

A color filter CF and a micro lens ML may be arranged on the second surface 110F2 of the first semiconductor substrate 110.

The third stack ST3 may include a logic transistor LCT disposed on the first surface 130F1 of the third semiconductor substrate 130, and the logic transistor LCT may include a logic gate LCG and a source/drain region LCS. The front structure FS3 may be disposed on the first surface 130F1 of the third semiconductor substrate 130, and the front structure FS3 may include a wiring layer 134 and a cover insulation layer 136.

The first surface 120F1 of the second semiconductor substrate 120 may be disposed to face the first surface 130F1 of the third semiconductor substrate 130, and the second insulation layer BI2 may be disposed between the first surface 120F1 of the second semiconductor substrate 120 and the first surface 130F1 of the third semiconductor substrate 130. The second insulation layer BI2 may have a stacked structure of a first sub-bonding layer BI2a and a second sub-bonding layer BI2b. According to embodiments, the first sub-bonding layer BI2a and the second sub-bonding layer BI2b may include silicon oxide or silicon carbon nitride.

According to the above-described embodiments, the transmission gate TG may be formed to extend from the second stack ST2 into the first stack ST1, and the transmission gate TG may be disposed to penetrate through the first insulation layer BI1. Therefore, as an insulation layer such as an interlayer insulation film and an etch stop layer is omitted between the first semiconductor substrate 110 and the second semiconductor substrate 120, a vertical distance between the first semiconductor substrate 110 and the second semiconductor substrate 120 may be reduced, and noise of the pixel PX may be reduced as a distance from the second contact CT2 to the floating diffusion region FD is reduced.

FIG. 7 is a circuit diagram of pixels PX of an image sensor according to embodiments.

Referring to FIG. 7, the plurality of pixels PX may be arranged in a matrix-like shape. At least one pixel PX may include the transmission transistor TX and pixel transistors. Here, the pixel transistors may include the reset transistor RX, the select transistor SX, and the source follower transistor SFX. The reset transistor RX may include a reset gate RG, the select transistor SX may include a select gate SG, and the transmission transistor TX may include a transmission gate TG.

The at least one pixel PX may further include a photoelectric conversion region PD and the floating diffusion region FD. The photoelectric conversion region PD may correspond to the photoelectric conversion region PD described above with reference to FIGS. 1 to 6. The photoelectric conversion region PD may generate and accumulate photo charges in proportion to an amount of light incident from the outside and may include a photo diode, a photo transistor, photo gate, a pinned photo diode (PPD), and combinations thereof.

The transmission gate TG may transfer charges generated by the photoelectric conversion region PD to the floating diffusion region FD. The floating diffusion region FD may receive and cumulatively store electric charges generated by the photoelectric conversion region PD. The source follower transistor SFX may be controlled according to the amount of photocharges accumulated in the floating diffusion region FD.

The reset transistor RX may periodically reset charges accumulated in the floating diffusion region FD. A drain electrode of the reset transistor RX is connected to the floating diffusion region FD, and a source electrode is connected to a power voltage V_{DD}. When the reset transistor RX is turned on, the power voltage V_{DD} connected to the source electrode of the reset transistor RX is transferred to the floating diffusion region FD. When the reset transistor RX is turned on, charges accumulated in the floating diffusion region FD are discharged, and thus the floating diffusion region FD may be reset.

The source follower transistor SFX is connected to a current source positioned outside the pixels PX, functions as a source follower buffer amplifier, amplifies a potential change in the floating diffusion region FD, and outputs the amplified potential change to an output line V_{OUT}.

The selection transistor SX may select the plurality of pixels PX row-by-row, and, when the selection transistor SX is turned on, an output voltage generated by the source follower transistor SFX may be transmitted to the output line V_{OUT}.

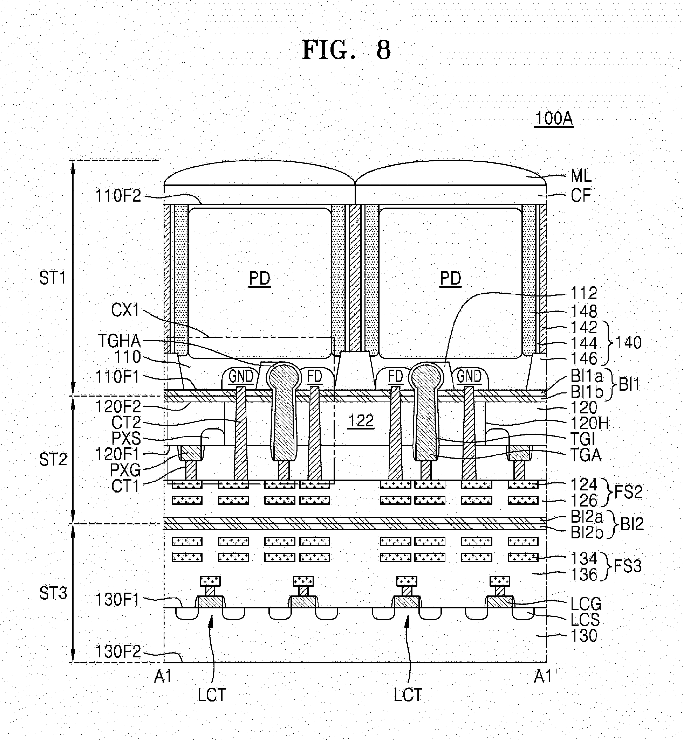

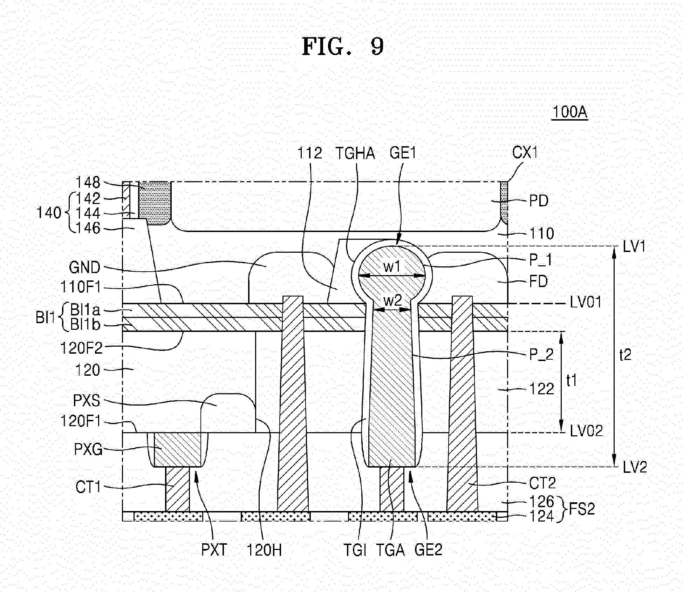

FIG. 8 is a cross-sectional view of an image sensor 100A according to embodiments. FIG. 9 is an enlarged view of a portion CX1 of FIG. 8. In FIGS. 8 and 9, reference numerals same as those in FIGS. 1 to 7 denote the same elements.

Referring to FIGS. 8 and 9, a transmission gate trench TGHA may have an inner wall in which a portion extending into the first semiconductor substrate 110 is rounded, and a transmission gate TGA disposed in the transmission gate trench TGHA may have a rounded sidewall corresponding to the shape of the rounded inner wall of the transmission gate trench TGHA. The width w1 of a first portion P_1 of the transmission gate TG positioned inside the first semiconductor substrate 110 may be greater than the width w2 of a second portion P_2 of the transmission gate TG surrounded by the first insulation layer BI1.

According to embodiments, after the second semiconductor substrate 120 and the first semiconductor substrate 110 are attached to each other via the first insulation layer BI1 therebetween, the transmission gate trench TGHA may be formed by sequentially etching the filling insulation layer 122, the first insulation layer BI1, and a portion of the first semiconductor substrate 110 adjacent to the first surface 110F1 from the first surface 120F1 of the second semiconductor substrate 120. In the process of forming the transmission gate trench TGHA by removing a portion of the first semiconductor substrate 110, when the portion of the first semiconductor substrate 110 is removed using an etching condition having isotropic etching characteristics, the transmission gate trench TGHA may have a shape that extends laterally and has a rounded inner wall. Also, by forming the transmission gate TG on the inner wall of the transmission gate trench TGHA, the sidewall of the first portion P_1 of the transmission gate TG may have a shape protruding outward from the sidewall of the second portion P_2 of the transmission gate TG.

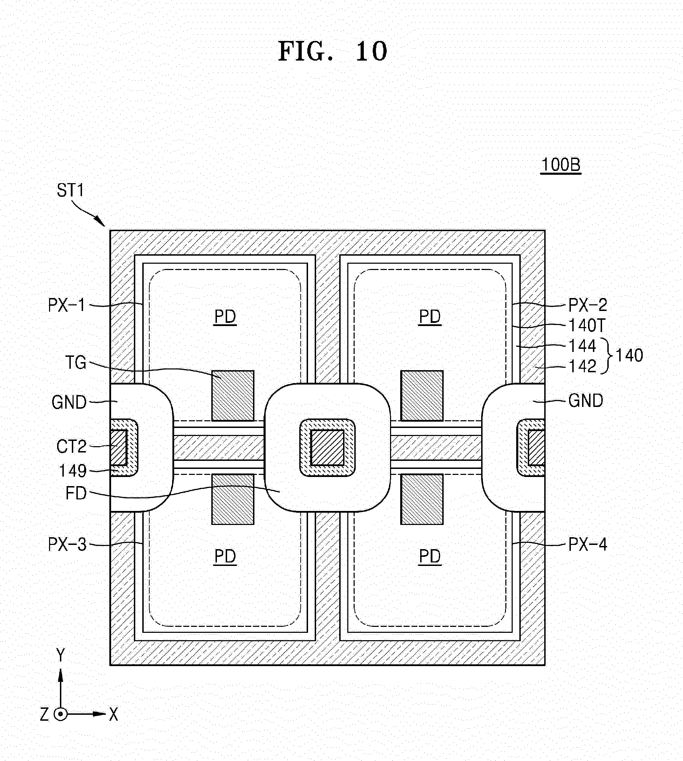

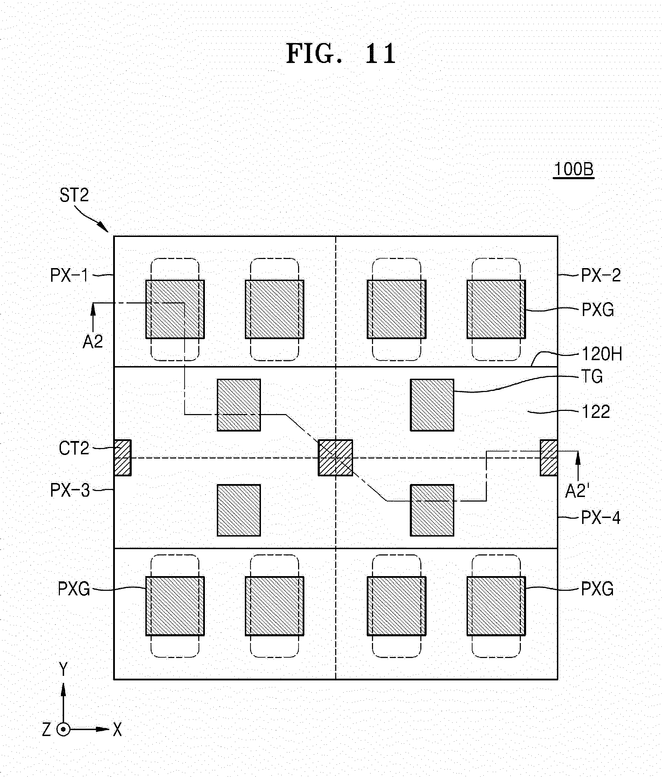

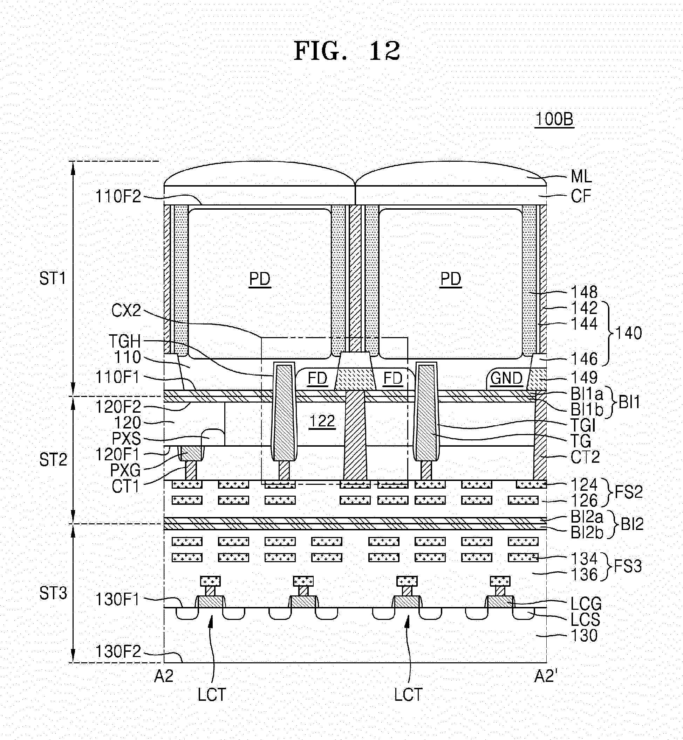

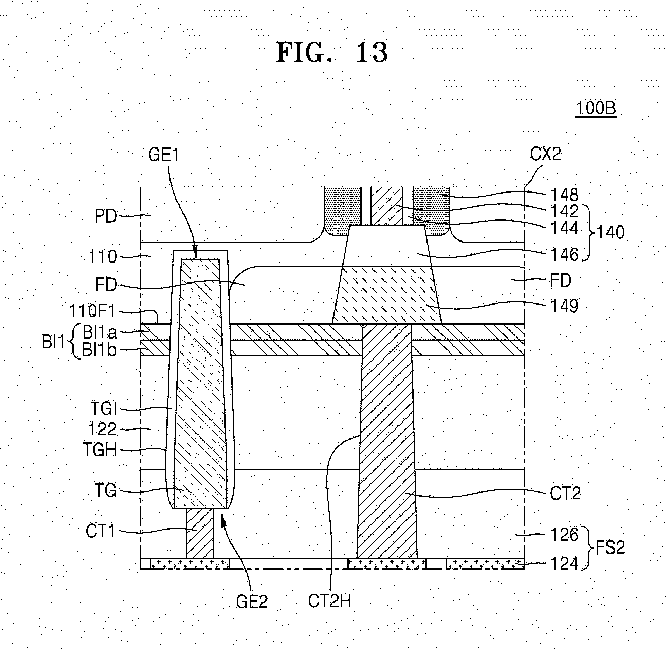

FIG. 10 is a layout diagram of the first stack ST1 of an image sensor 100B according to embodiments, and FIG. 11 is a layout of the second stack ST2 of the image sensor 100B according to embodiments. FIG. 12 is a cross-sectional view taken along a line A2-A2' of FIG. 11 and FIG. 13 is an enlarged view of CX2 of FIG. 12. In FIGS. 10 to 13, reference numerals same as those in FIGS. 1 to 9 denote the same elements.

Referring to FIGS. 10 to 13, a conductive layer 149 may be disposed on the upper insulation layer 146 of the pixel isolation structure 140, and, in a plan view, the conductive layer 149 may be surrounded by the floating diffusion region FD and surrounded by the ground region GND. According to embodiments, the conductive layer 149 may have a bottom surface disposed on the same plane as the first surface 110F1 of the first semiconductor substrate 110, and the bottom surface of the conductive layer 149 may be disposed to contact the first insulation layer BI1. According to embodiments, the conductive layer 149 may include polysilicon or a metal.

The second contact CT2 may penetrate through the filling insulation layer 122 and the first insulation layer BI1 and extend in the vertical direction Z to be electrically connected to the conductive layer 149. According to some embodiments, as shown in FIG. 10, the second contact CT2 and the conductive layer 149 connected thereto may be arranged on the floating diffusion region FD shared by first to fourth pixels PX-1 to PX-4, and the second contact CT2 may be shared by the first to fourth pixels PX-1 to PX-4.

According to embodiments, after forming the pixel isolation structure 140 penetrating through the first semiconductor substrate 110, a recess process for removing a portion of the upper insulation layer 146 may be performed, and the conductive layer 149 may be formed in a recessed space from which the portion of the upper insulation layer 146 is removed. Thereafter, after the second semiconductor substrate 120 is attached onto the first surface 110F1 of the first semiconductor substrate 110, a second contact hole CT2H penetrating through the filling insulation layer 122 and the first insulation layer BI1 may be formed, and the second contact CT2 may be formed by filling the second contact hole CT2H with a metal material.

According to the above-described embodiments, the second contact CT2 electrically connected to the floating diffusion region FD and the ground region GND may be formed at a position overlapping the pixel isolation structure 140, thus being advantageous for size reduction of pixels. Also, as the vertical distance between the first semiconductor substrate 110 and the second semiconductor substrate 120 decreases, the distance from the second contact CT2 to the floating diffusion region FD decreases, and thus pixel noise may be reduced.

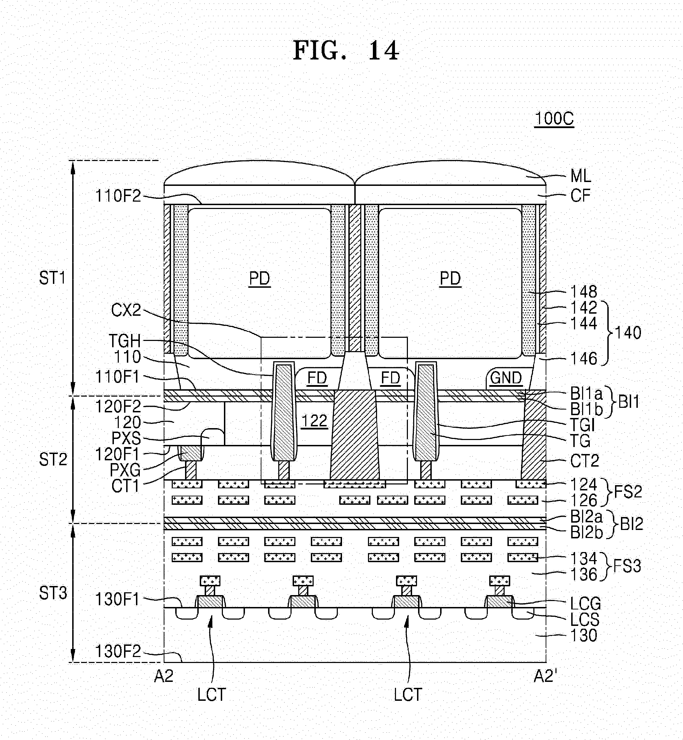

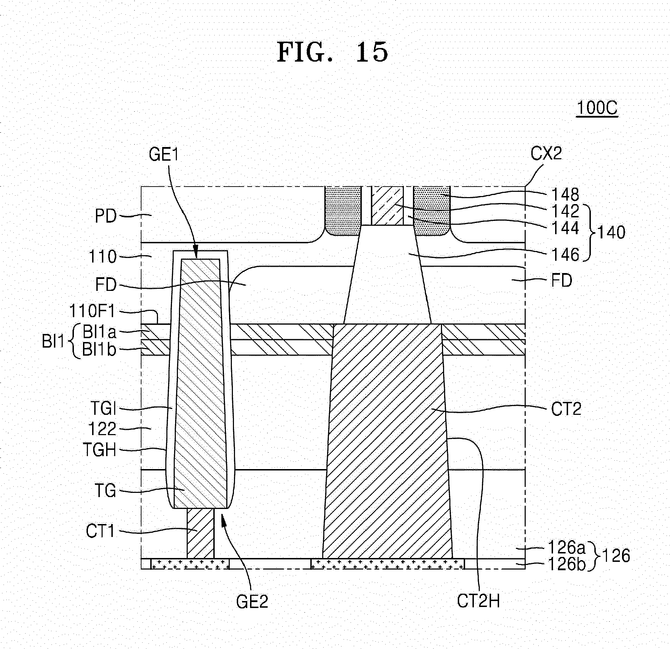

FIG. 14 is a cross-sectional view of an image sensor 100C according to embodiments, and FIG. 15 is an enlarged view of CX2 of FIG. 14.

Referring to FIGS. 14 and 15, the conductive layer 149 described above with reference to FIGS. 10 to 13 may be omitted. The bottom surface of the upper insulation layer 146 (the surface of the upper insulation layer 146 facing the second semiconductor substrate 120, as shown in FIG. 15) may be disposed on the same plane as the first surface 110F1 of the first semiconductor substrate 110, and the first insulation layer BI1 may be disposed on the bottom surface of the upper insulation layer 146. The second contact CT2 may be disposed to penetrate through the filling insulation layer 122 and the first insulation layer BI1 and contact the bottom surface of the upper insulation layer 146 and the floating diffusion region FD, and the second contact CT2 may be formed to have a greater width than the upper insulation layer 146.

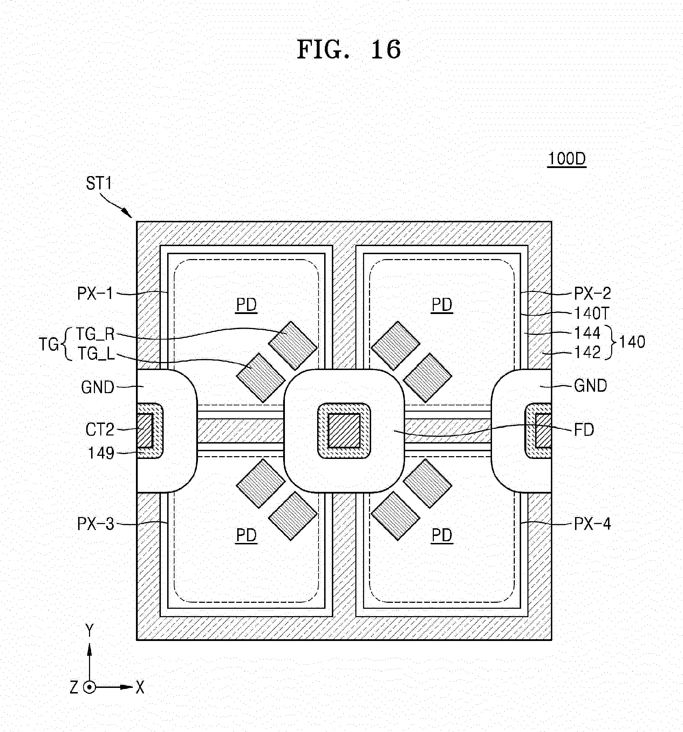

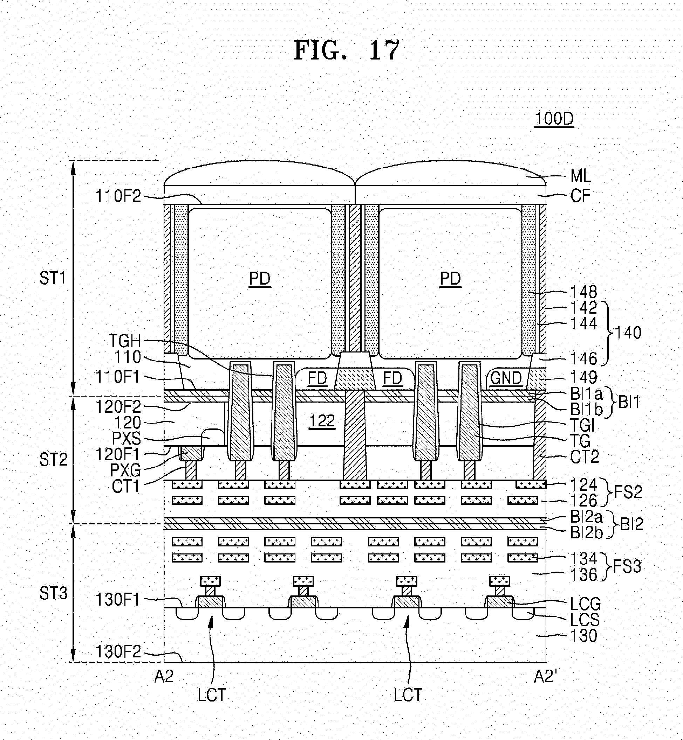

FIG. 16 is a layout diagram showing an image sensor 100D according to embodiments, and FIG. 17 is a cross-sectional view of the image sensor 100D.

Referring to FIG. 17, the transmission gate TG may be a dual-type transmission gate. For example, two transmission gates TG may be arranged in one pixel. For example, the transmission gate TG may include a first gate TG_L and a second gate TG_R spaced apart from each other. According to some embodiments, as shown in FIG. 16, the first gate TG_L and the second gate TG_R may be arranged to be the same distance apart from the floating diffusion region FD.

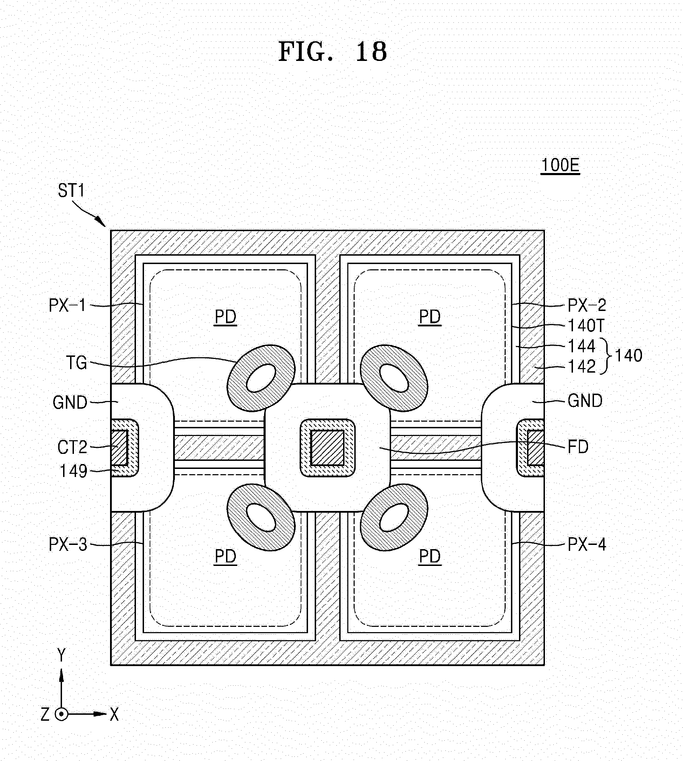

FIG. 18 is a layout diagram showing an image sensor 100E according to embodiments.

Referring to FIG. 18, the transmission gate TG may be a gate all-around type transmission gate. For example, the transmission gate TG may have a ring-like or annular horizontal cross-sectional shape.

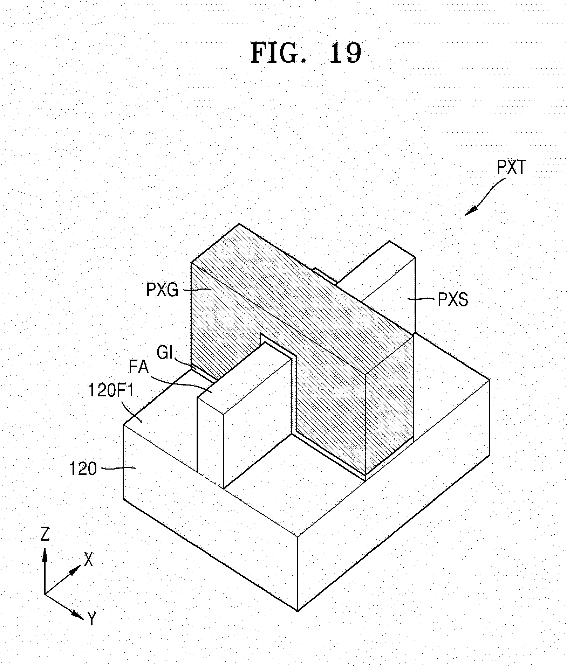

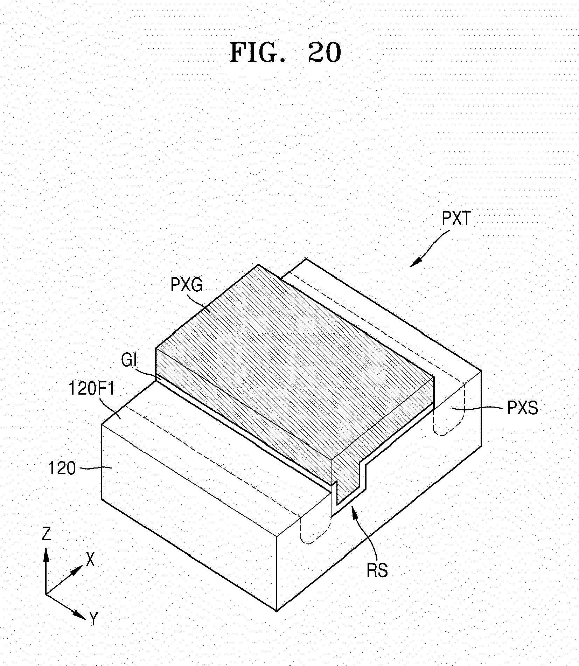

FIGS. 19 and 20 are diagrams schematically showing pixel transistors PXT that may be employed in an image sensor according to embodiments.

Referring to FIG. 19, the pixel transistor PXT may be a FinFET transistor.

FIG. 19 shows an example in which the first surface 120F1 of the second semiconductor substrate 120 faces upward. The pixel transistor PXT may include a fin-type active region FA formed on the first surface 120F1 of the second semiconductor substrate 120 and protruding in the vertical direction Z, the pixel gate PXG disposed across the fin-type active region FA, and source/drain region PXS disposed on both sides of the fin-type active region FA. A gate insulation layer GI may be disposed between the pixel gate PXG and the fin-type active region FA.

Referring to FIG. 20, the pixel transistor PXT may be a transistor having a gamma gate structure. FIG. 20 shows an example in which the first surface 120F1 of the second semiconductor substrate 120 faces upward. The pixel transistor PXT may include the pixel gate PXG, and at least a portion of the pixel gate PXG may be disposed in a recess RS formed in the first surface 120F1 of the second semiconductor substrate 120. At least another portion of the pixel gate PXG may have a planar structure disposed on the first surface 120F1 of the second semiconductor substrate 120. The gate insulation layer GI may be disposed between the pixel gate PXG and the first surface 120F1 of the second semiconductor substrate 120, and the gate insulation layer GI may conformally extend onto the inner wall of the recess RS.

FIGS. 19 and 20 show examples in which the pixel transistor PXT is a FinFET transistor or a gamma gate transistor. In one embodiment, the pixel transistor PXT may also be one of various other types of transistors including a vertical channel transistor, a multi-bridge channel transistor, or a 3D stacked transistor.

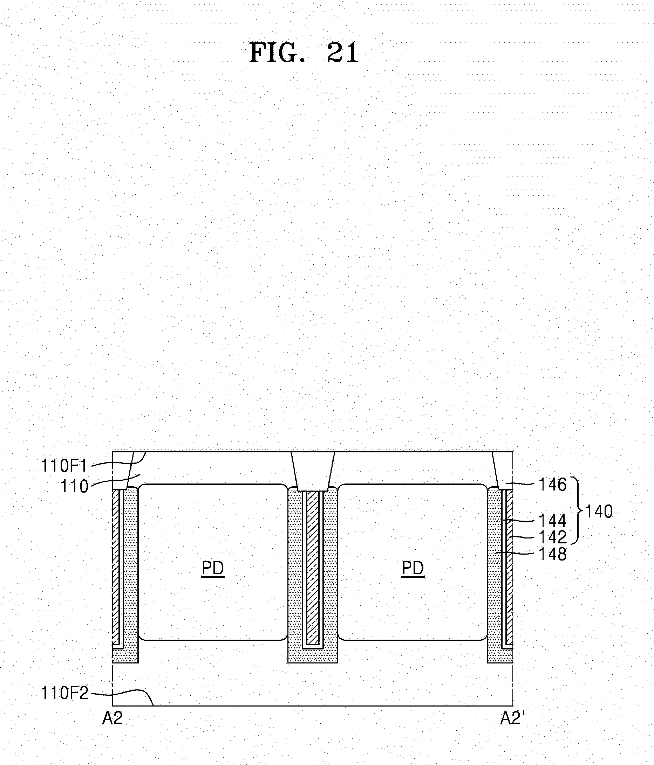

FIGS. 21 to 33 are cross-sectional views of an operational procedure of manufacturing the image sensor 100B according to example embodiments. FIGS. 21 to 33 are cross-sectional views corresponding to a cross-section taken along a line A2-A2' of FIG. 11.

Referring to FIG. 21, the first semiconductor substrate 110 having the first surface 110F1 and the second surface 110F2 opposite to each other is prepared.

The photoelectric conversion region PD may be formed from the first surface 110F1 of the first semiconductor substrate 110 through an ion implantation process. For example, the photoelectric conversion region PD may be formed by implanting an n-type impurity.

Thereafter, a mask pattern may be formed on the first surface 110F1 of the first semiconductor substrate 110, and the pixel trench 140T may be formed in the first semiconductor substrate 110 by using the mask pattern as an etching mask. The pixel trench 140T may have a certain depth from the first surface 110F1 and may be formed in a matrix-like shape in a plan view.

Thereafter, the insulation liner 144 may be conformally formed on the inner wall of the pixel trench 140T through a chemical vapor deposition (CVD) process or an atomic layer deposition (ALD) process. Thereafter, the conductive layer 142 filling the interior of the pixel trench 140T may be formed on the insulation liner 144. The conductive layer 142 may include at least one of doped polysilicon, a metal, a metal silicide, a metal nitride, or a metal-containing layer.

Thereafter, the upper portion of the conductive layer 142 may be removed through a process such as an etch-back process until the top surface of the conductive layer 142 reaches a level lower than that of the top of the first surface 110F1 of the first semiconductor substrate 110, an insulation layer may be formed to fill the inlet of the pixel trench 140T, and the insulation layer may be removed until the top surface of the first semiconductor substrate 110 is exposed, thereby leaving the upper insulation layer 146 in the inlet of the pixel trench 140T.

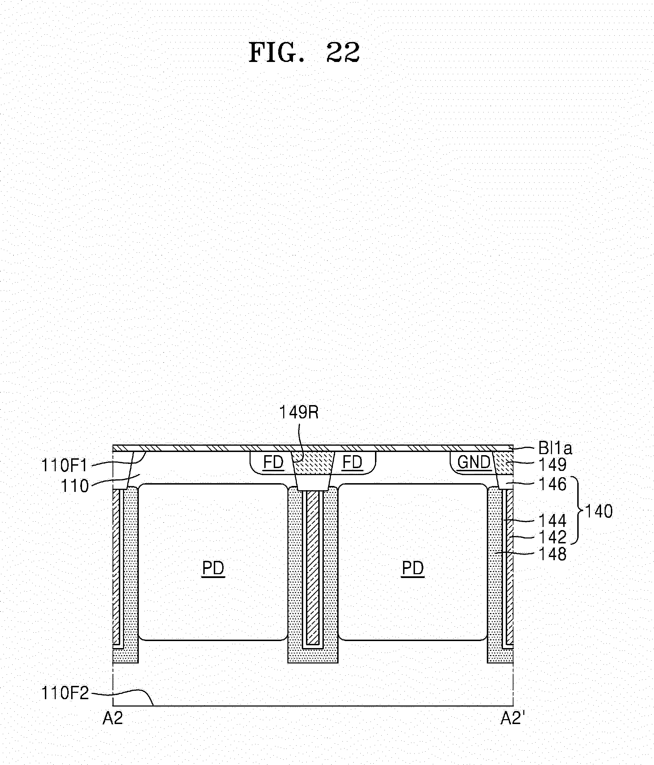

Referring to FIG. 22, a portion of the upper insulation layer 146 may be removed through a recess process, thereby forming a recessed region 149R. The conductive layer 149 may be formed by using polysilicon or a metal in the recessed region 149R.

According to embodiments, a planarization process may be performed on an upper portion of the conductive layer 149, and thus the top surface of the conductive layer 149 may be disposed on the same plane as the first surface 110F1 of the first semiconductor substrate 110.

Thereafter, the floating diffusion region FD and the ground region GND may be formed from the first surface 110F1 through an ion implantation process. For example, the floating diffusion region FD may be formed by implanting an n-type impurity.

Thereafter, the first sub-bonding layer BI1a is formed on the first surface 110F1 of the first semiconductor substrate 110.

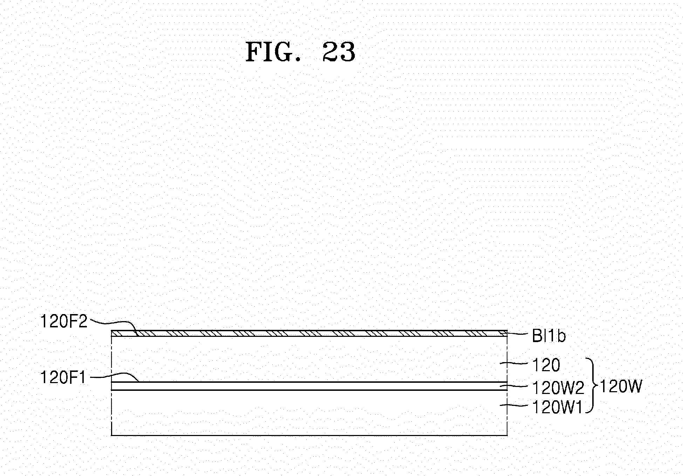

Referring to FIG. 23, a wafer 120W including the second semiconductor substrate 120 is prepared. The wafer 120W may be an SOI type substrate and may have, for example, a structure in which a base substrate 120W1, an insulation layer 120W2, and the second semiconductor substrate 120 are stacked.

Thereafter, the second sub-bonding layer BI1b may be formed on the wafer 120W, e.g., on the second semiconductor substrate 120.

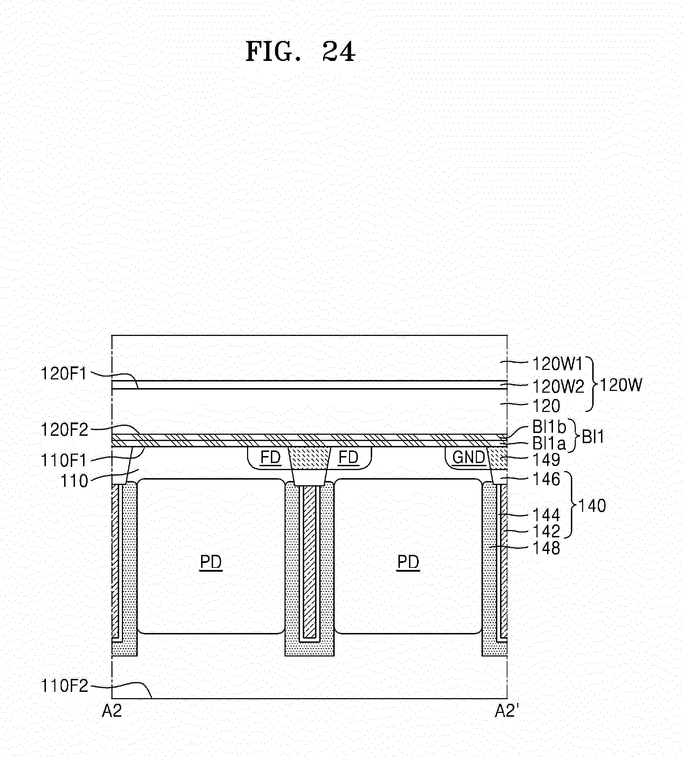

Referring to FIG. 24, the second surface 110F2 of the second semiconductor substrate 120 may be attached onto the first surface 110F1 of the first semiconductor substrate 110 by bringing the first sub-bonding layer BI1a and the second sub-bonding layer BI1b into contact with each other.

According to embodiments, the first sub-bonding layer BI1a and the second sub-bonding layer BI1b may form a bonding interface having a flat level and may be referred together to as the first insulation layer BI1.

As the second surface 110F2 of the second semiconductor substrate 120 is attached onto the first surface 110F1 of the first semiconductor substrate 110, the base substrate 120W1 and the insulation layer 120W2 may be arranged to face upward.

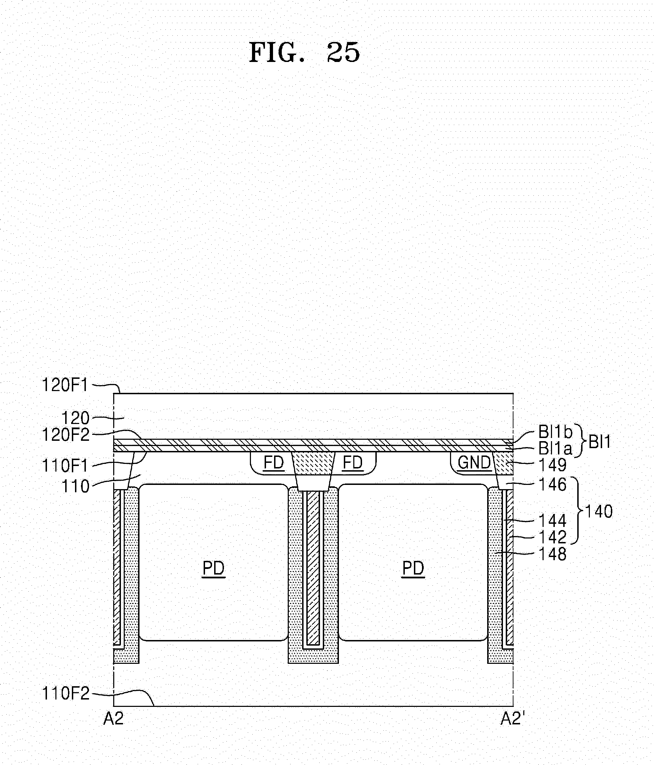

Referring to FIG. 25, the base substrate 120W1 and the insulation layer 120W2 may be removed. According to embodiments, at least one of a chemical mechanical polishing process, a grinding process, and a wet etching process may be performed to remove the base substrate 120W1 and the insulation layer 120W2. After removing the base substrate 120W1 and the insulation layer 120W2, the first surface 120F1 of the second semiconductor substrate 120 may be exposed.

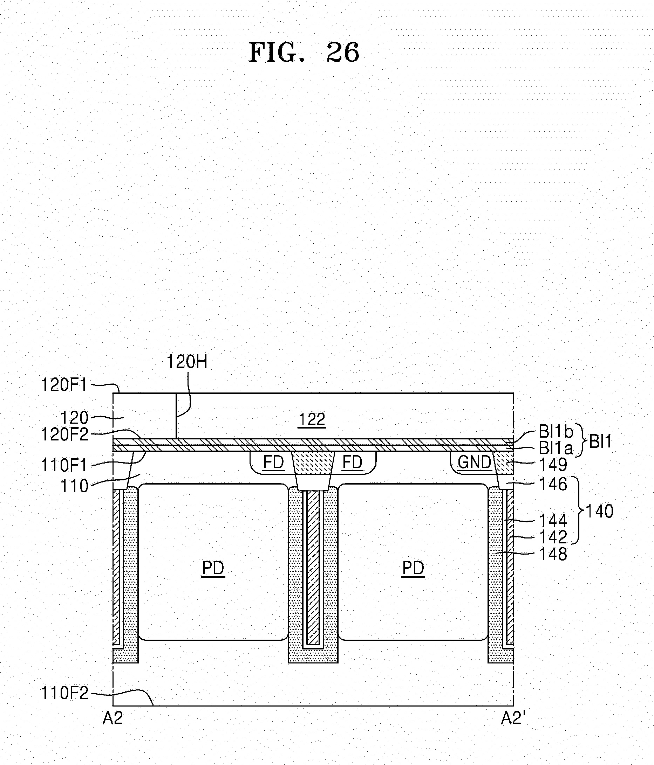

Referring to FIG. 26, the opening 120H may be formed by removing a portion of the second semiconductor substrate 120, and the filling insulation layer 122 may be formed in the opening 120H by using an insulation material.

The upper portion of the filling insulation layer 122 may be planarized, and thus the top surface of the filling insulation layer 122 may be disposed at the same level as the first surface 120F1 of the second semiconductor substrate 120.

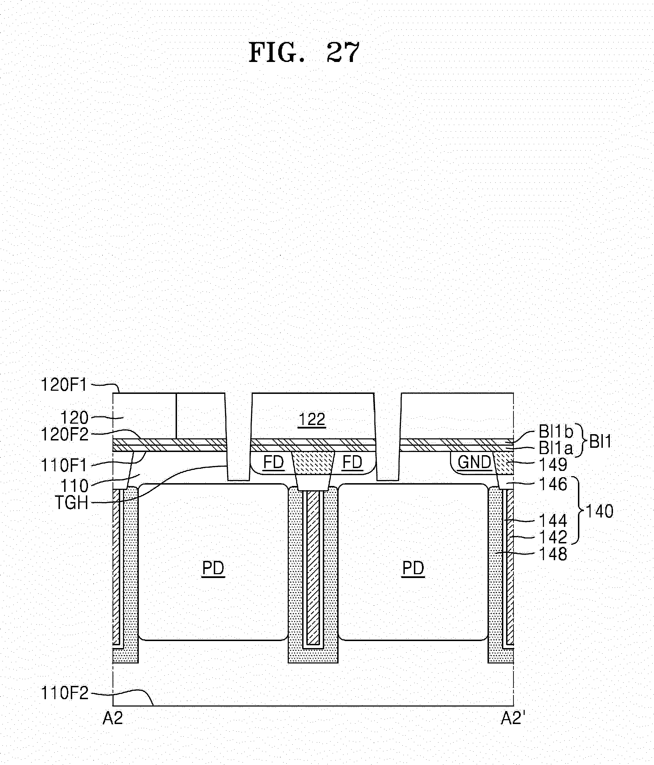

Referring to FIG. 27, a mask pattern may be formed on the filling insulation layer 122, the transmission gate trench TGH may be formed by removing portions of the filling insulation layer 122, the first insulation layer BI1, and the first semiconductor substrate 110 by using the mask pattern as an etching mask. According to some embodiments, the transmission gate trench TGH may have an inclined sidewall, such that an upper portion of the transmission gate trench TGH has a width greater than a bottom portion of the transmission gate trench TGH.

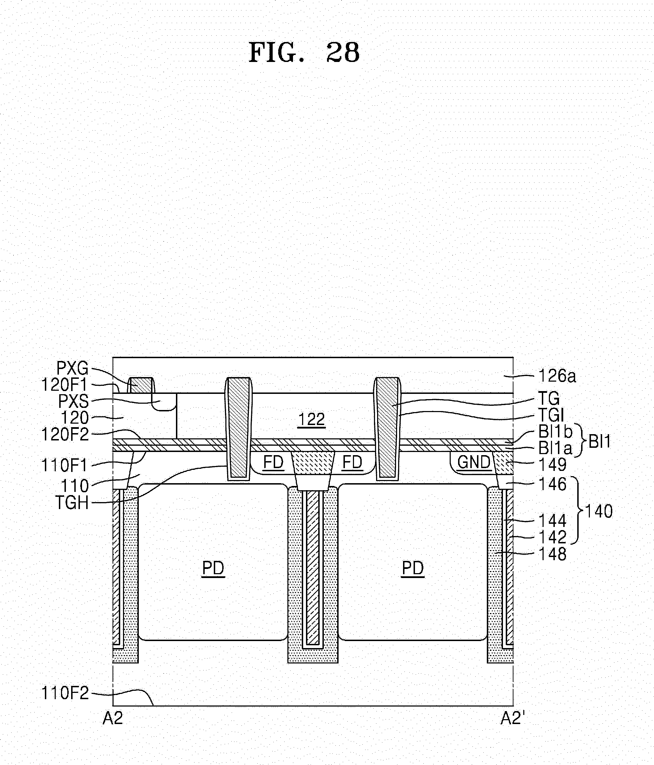

Referring to FIG. 28, the pixel gate PXG may be formed on the first surface 120F1 of the second semiconductor substrate 120 and the transmission gate TG may be formed in the transmission gate trench TGH. According to embodiments, the pixel gate PXG and the transmission gate TG may be formed by using at least one of doped polysilicon, a metal, a metal silicide, a metal nitride, or a metal-containing layer.

According to embodiments, before forming the transmission gate TG, the transmission gate insulation layer TGI may be conformally formed on the inner wall of the transmission gate trench TGH.

Thereafter, the first cover insulation layer 126a covering the pixel gate PXG and the transmission gate TG may be formed on the first surface 120F1 of the second semiconductor substrate 120. The first cover insulation layer 126a may be formed to have a sufficiently large thickness to completely cover the pixel gate PXG and the transmission gate TG.

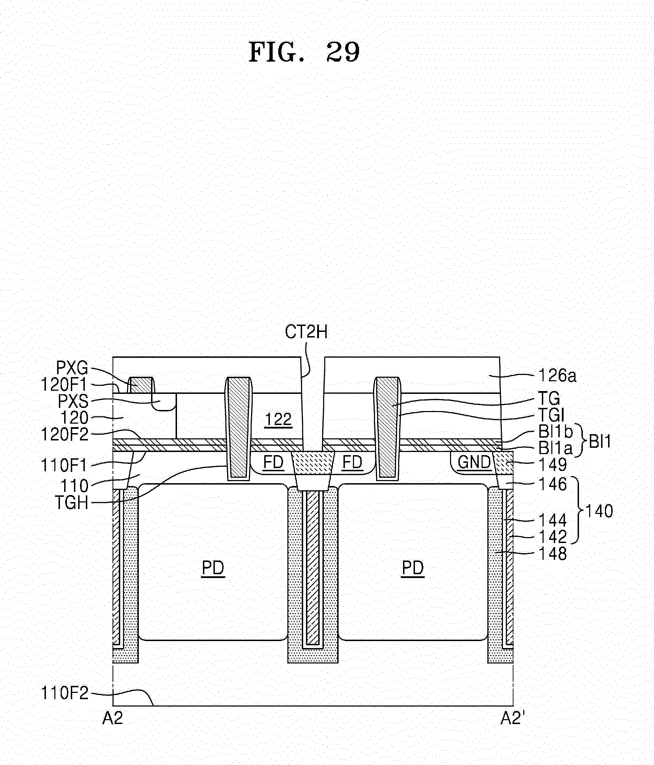

Referring to FIG. 29, the second contact hole CT2H penetrating through the first cover insulation layer 126a, the filling insulation layer 122, and the first insulation layer BI1 and exposing the top surface of the conductive layer 149 may be formed.

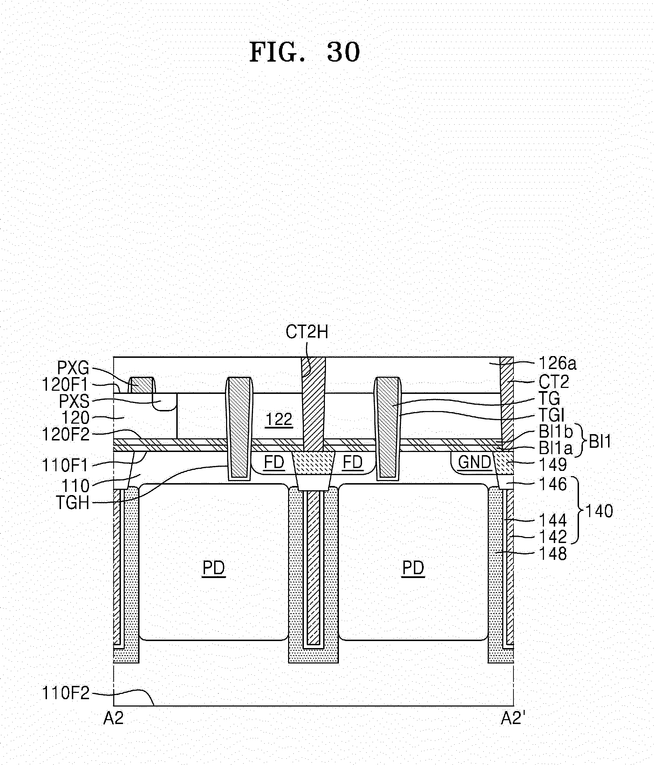

Referring to FIG. 30, the second contact CT2 may be formed in the second contact hole CT2H. The second contact CT2 may be electrically connected to the conductive layer 149 surrounded by the floating diffusion region FD or the ground region GND.

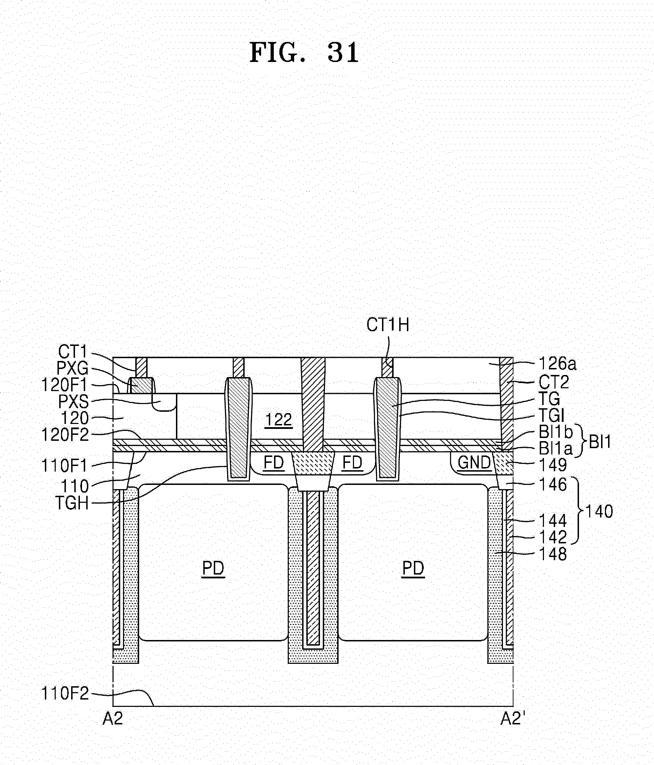

Referring to FIG. 31, a first contact hole CT1H penetrating through the first cover insulation layer 126a and exposing the top surfaces of the pixel gate PXG and the transmission gate TG may be formed. Thereafter, the first contact CT1 may be formed in the first contact hole CT1H.

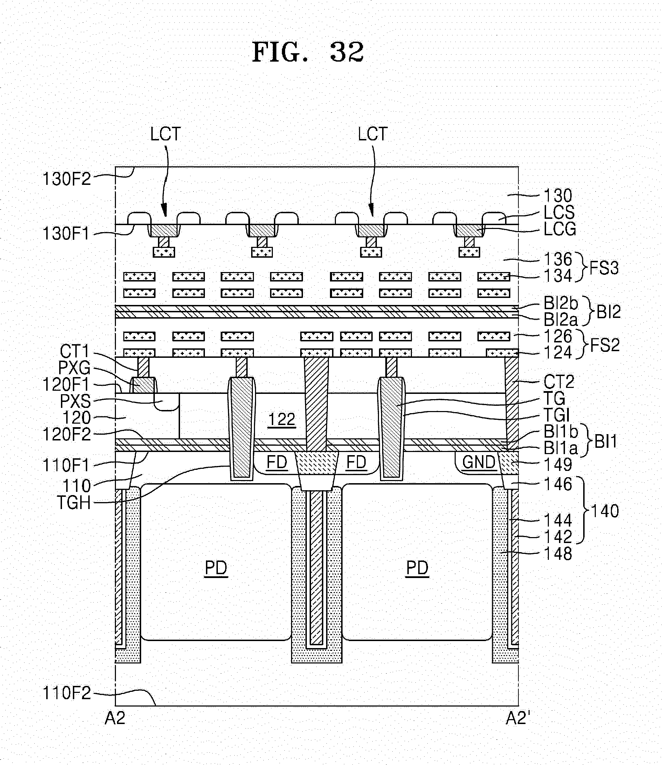

Referring to FIG. 32, a wiring layer 124 and the second cover insulation layer 126b may be formed on the first cover insulation layer 126a.

Thereafter, the third semiconductor substrate 130 may be attached onto the front structure FS2 including the first cover insulation layer 126a, the second cover insulation layer 126b, and the wiring layer 124 with the second insulation layer BI2 therebetween. The third semiconductor substrate 130 may include the first surface 130F1 and the second surface 130F2 and may be attached onto the second semiconductor substrate 120 while the logic transistor LCT is formed on the first surface 130F1.

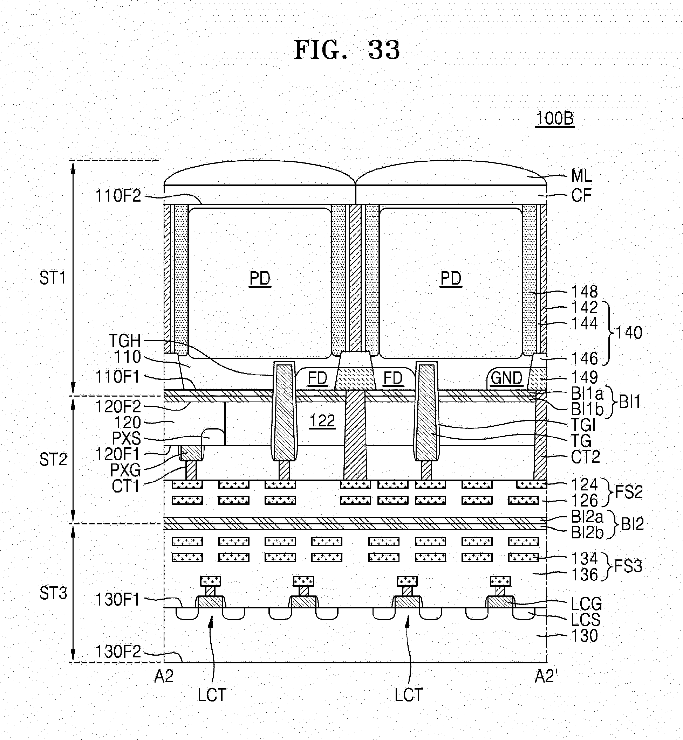

Referring to FIG. 33, the stacked structure of FIG. 32 may be turned upside down, such that the second surface 110F2 of the first semiconductor substrate 110 faces upward. Thereafter, a portion of the first semiconductor substrate 110 may be removed from the second surface 110F2 of the first semiconductor substrate 110 through a planarization process such as a CMP process or an etchback process until the top surface of the pixel isolation structure 140 (e.g., an end portion adjacent to the second surface 110F2 of the first semiconductor substrate 110) is exposed.

In one embodiment, a rear insulation layer may be formed on the second surface 110F2 of the first semiconductor substrate 110. The rear insulation layer may include a metal oxide and function as a negative charge fixing layer.

Thereafter, the color filter CF and the micro lens ML may be formed on the second surface 110F2 of the first semiconductor substrate 110 in the active pixel region APR.

The image sensor 100B may be completed through above-stated operations.

According to the embodiments described above, after attaching the first semiconductor substrate 110 and the second semiconductor substrate 120 to each other, the transmission gate TG and the second contact CT2 penetrating through the second semiconductor substrate 120 and extending into the first semiconductor substrate 110 may be formed. Therefore, as compared to a manufacturing procedure according to a comparative example in which the transmission gate TG is formed on the first semiconductor substrate 110 and the first semiconductor substrate 110 is attached thereafter to the second semiconductor substrate 120, a distance between the first semiconductor substrate 110 and the second semiconductor substrate 120 may be reduced. Therefore, noise of the image sensor 100B may be reduced, e.g., a resistance of the second contact CT2 connected to the floating diffusion region FD may be reduced, and excellent image quality may be obtained.

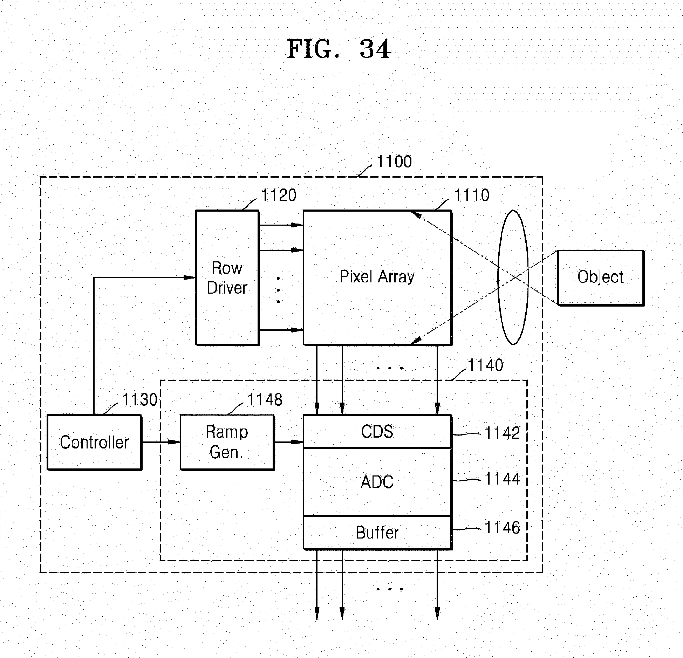

FIG. 34 is a block diagram showing the configuration of an image sensor 1100 according to an embodiment.

Referring to FIG. 34, the image sensor 1100 may include a pixel array 1110, a controller 1130, a row driver 1120, and a pixel signal processor 1140. The image sensor 1100 may include at least one of image sensors 100, 100A, 100B, 100C, 100D, and 100E described above with reference to FIGS. 1 to 20.

The pixel array 1110 may include a plurality of unit pixels that are 2-dimensionally arranged, and at least one unit pixel may include a photoelectric conversion element. The photoelectric conversion element may absorb light to generate charges and an electric signal (output voltage) based on generated charges may be provided to the pixel signal processor 1140 through a vertical signal line. Unit pixels included in the pixel array 1110 may provide one output voltage at a time row-by-row, and thus unit pixels belonging to one row of the pixel array 1110 may be simultaneously activated by a selection signal output by the row driver 1120. Unit pixels belonging to a selected row may provide an output voltage according to absorbed light to an output line of a corresponding column.

The controller 1130 may control the row driver 1120, such that the pixel array 1110 absorbs light and accumulates charges or temporarily stores accumulated charges and outputs electric signals according to stored charges to the outside of the pixel array 1110. Also, the controller 1130 may control the pixel signal processor 1140 to measure an output voltage provided by the pixel array 1110.

The pixel signal processor 1140 may include a correlation double sampler (CDS) 1142, an analog-digital converter (ADC) 1144, and a buffer 1146. The CDS 1142 may sample and hold an output voltage provided by the pixel array 1110. The CDS 1142 may double sample a particular noise level and a level according to a generated output voltage and output a level corresponding to a difference therebetween. Also, the CDS 1142 may receive ramp signals generated by a ramp signal generator 1148, compare them with each other, and output a result of the comparison.

The ADC 1144 may convert an analog signal corresponding to a level received from the CDS 1142 into a digital signal. The buffer 1146 may latch digital signals, and latched signals may be sequentially output to the outside of the image sensor 1100 and transmitted to an image processor.

While the disclosure has been particularly shown and described with reference to embodiments thereof, various changes in form and details may be made therein without departing from the scope of the following claims.

## Claims

1. An image sensor comprising:
a first stack comprising:
a first semiconductor substrate comprising a first surface and a second surface opposite to the first surface,
a photoelectric conversion region in the first semiconductor substrate, and
a floating diffusion region in the first semiconductor substrate, the floating diffusion region being configured to store charges transferred from the photoelectric conversion region;
a second stack comprising:
a second semiconductor substrate comprising a first surface and a second surface opposite the first surface, and
a transmission gate penetrating through the second semiconductor substrate and extending into the first stack; and
an insulation layer between the first stack and the second stack.

2. The image sensor of claim 1, wherein the insulation layer covers at least a portion of a sidewall of the transmission gate.

3. The image sensor of claim 2, wherein the insulation layer is disposed between the first surface of the first semiconductor substrate and the second surface of the second semiconductor substrate.

4. The image sensor of any one of claims 1 to 3, wherein the second stack further comprises a filling insulation layer in an opening penetrating through the second semiconductor substrate, and
wherein the transmission gate penetrates through the filling insulation layer and the insulation layer and extends in a vertical direction.

5. The image sensor of any one of claims 1 to 4, wherein the insulation layer comprises: a first sub-bonding layer attached on the first surface of the first semiconductor substrate; and a second sub-bonding layer attached on the second surface of the second semiconductor substrate, and
wherein the first sub-bonding layer and the second sub-bonding layer are arranged throughout an area between the first stack and the second stack.

6. The image sensor of claim 5, wherein the first sub-bonding layer or the second sub-bonding layer comprises at least one of silicon oxide or silicon carbon nitride.

7. The image sensor of any one of claims 1 to 6, wherein the first stack further comprises a pixel device isolation layer in a pixel trench penetrating through the first semiconductor substrate,
wherein the pixel device isolation layer comprises a plurality of pixels in the first stack, and
wherein the photoelectric conversion region and the floating diffusion region are provided in at least one pixel of the plurality of pixels.

8. The image sensor of claim 7, wherein the first stack further comprises a conductive layer vertically overlapping at least a portion of the pixel device isolation layer at a position adjacent to the first surface of the first semiconductor substrate, and
wherein the floating diffusion region surrounds the conductive layer in a plan view.

9. The image sensor of claim 8, wherein the second stack further comprises a contact that penetrates through the second semiconductor substrate and that is connected to the conductive layer, and
wherein a portion of a sidewall of the contact is covered by the insulation layer.

10. The image sensor of any one of claims 1 to 9, wherein the second stack further comprises a pixel gate on the first surface of the second semiconductor substrate,
wherein the image sensor further comprises a third stack attached to the second stack, and
wherein the third stack comprises a logic transistor configured to provide signals to the pixel gate and the transmission gate.

11. The image sensor according to claim 1, wherein:
the first surface of the second semiconductor substrate faces the first surface of the first semiconductor substrate,
the second stack further comprises a pixel gate on the first surface of the second semiconductor substrate,
the transmission gate comprises a first end portion disposed at a level higher than that of the first surface of the first semiconductor substrate and a second end portion disposed at a level lower than that of the first surface of the second semiconductor substrate, and
a portion of a sidewall of the transmission gate is surrounded by the insulation layer.

12. The image sensor of claim 11, wherein the second stack further comprises a filling insulation layer in an opening penetrating through the second semiconductor substrate, and
wherein the transmission gate penetrates through the filling insulation layer and the insulation layer and extends in a vertical direction.

13. The image sensor of claim 12, wherein the second semiconductor substrate has a first thickness in the vertical direction, and
wherein the transmission gate has a second thickness greater than the first thickness in the vertical direction.

14. The image sensor of claim 12 or 13, wherein the insulation layer comprises:
a first sub-bonding layer on the first surface of the first semiconductor substrate; and
a second sub-bonding layer on the second surface of the second semiconductor substrate, and
wherein the first sub-bonding layer and the second sub-bonding layer are arranged throughout an area between the first stack and the second stack.

15. The image sensor of any one of claims 12 to 14, wherein the second stack further comprises a contact that penetrates through the filling insulation layer and the insulation layer and that is electrically connected to the floating diffusion region.
